# EUROPÄISCHE PATENTSCHRIFT

(11) **EP 1 121 846 B1**
(45) Veröffentlichungstag und Bekanntmachung des Hinweises auf die Patenterteilung: **29.11.2006**
(21) Anmeldenummer: 00958221.4
(22) Anmeldetag: 08.08.2000
(51) Int. Cl.: H05K 13/02

(54) **VORRICHTUNG ZUM TRANSPORT VON GEGENSTÄNDEN UND VERWENDUNG DER VORRICHTUNG**
DEVICE FOR TRANSPORTING OBJECTS AND USE OF SAID DEVICE
DISPOSITIF DESTINE AU TRANSPORT D'OBJETS ET SON UTILISATION

(30) Priorität: 12.08.1999 DE 19938061
(43) Veröffentlichungstag der Anmeldung: 08.08.2001
(73) Patentinhaber: SIEMENS AKTIENGESELLSCHAFT, 80333 München (DE)
(72) Erfinder: LINTNER, Albert, D-83714 Miesbach (DE)
(86) Internationale Anmeldenummer: PCT/DE2000/002645
(87) Internationale Veröffentlichungsnummer: WO 2001/013696

(56) Entgegenhaltungen:
- EP-A- 0 452 038
- EP-A- 0 688 159

## Beschreibung

Die Erfindung betrifft eine Vorrichtung zum Transport von Gegenständen mittels eines Luftstromes in einem Kanal. Ferner betrifft die Erfindung die Verwendung der Vorrichtung.

Aus EP 0 216 203 B1 ist eine Vorrichtung zum Transport von Gegenständen mittels eines Luftstromes in einem Kanal bekannt, bei der der Kanal gebildet ist durch einen quaderförmigen Körper, der eine im wesentlichen U-förmige sich über die Länge des Kanals erstreckende Ausnehmung aufweist, die mit einer Platte abgedeckt wird.

Die U-Form des Kanals hat den Nachteil, daß er insbesondere in der für Gegenstände mit Abmessungen kleiner als 0,6 mm × 0,6 mm erforderlichen miniaturisierten Dimension nicht mit der erforderlichen Maßhaltigkeit und Glattheit der Oberfläche hergestellt werden kann. Die Folge davon ist, daß die Gegenstände leicht im Kanal hängenbleiben.

Ziel der vorliegenden Erfindung ist es daher, eine Vorrichtung zum Transport von Gegenständen mittels eines Luftstromes in einem Kanal bereitzustellen, bei der der im Durchmesser an Gegenstände kleiner Abmessungen, insbesondere an Gegenstände mit Abmessungen kleiner als 0,6 mm × 0,6 mm, angepaßte Kanal mit einem Höchstmaß an Maßhaltigkeit und Glattheit der Wände hergestellt werden kann.

Dieses Ziel wird erfindungsgemäß durch eine Vorrichtung nach Anspruch 1 oder nach Anspruch 2 erreicht. Vorteilhafte Ausgestaltungen der Erfindung sowie bevorzugte Verwendungen der Erfindung sind den weiteren Ansprüchen zu entnehmen.

Die Erfindung gibt eine Vorrichtung zum Transport von Gegenständen mittels eines Luftstromes in einem Kanal an, bei der der Kanal geformt ist durch Zusammenfügen eines ersten Körpers mit einer konvexen Oberfläche und eines zweiten Körpers mit einer konkaven Oberfläche. Die Form der konkaven Oberfläche stimmt mit der Form der konvexen Oberfläche so überein, daß die beiden Körper formschlüssig zusammengefügt werden können. Die konvexe Oberfläche des ersten Körpers wird dabei beschrieben durch eine Zylinderfläche. Er weist eine geradlinige Ausnehmung auf, die zumindest Teile der konvexen Oberfläche umfaßt und parallel zur Längsachse des Zylinders verläuft. Diese Ausnehmung bildet zusammen mit dem formschlüssig angefügten zweiten Körper den Kanal.

Durch die erfindungsgemäße Formung des Kanals aus einem konvexen und einem konkaven Körper wird erreicht, daß ein wesentlicher Teil des Kanals bereits durch die Form der Körper vorgebildet ist. Der Kanal läßt sich somit beispielsweise durch einfaches gerades Abschneiden eines Teils der konvexen Oberfläche des ersten Körpers realisieren. Im Gegensatz zur Bildung eines U-förmigen Kanals läßt sich ein solcher Verarbeitungsschritt mit wesentlicher höherer Genauigkeit durchführen.

Ferner gibt die Erfindung eine Vorrichtung zum Transport von Gegenständen mittels eines Luftstromes in einem Kanal an, bei der der Kanal geformt ist durch Zusammenfügen zweier Körper, die von ebenen Flächen so begrenzt sind, daß sie formschlüssig zusammengefügt werden können. Dabei hat der erste Körper die Form eines gedachten geraden Prismas, wobei in dem Vieleck, das seine Grundfläche begrenzt, zwei Seiten einen Winkel α < 180° aufspannen. Der zweite Körper hat ebenfalls die Form eines geraden Prismas, wobei im seine Grundfläche begrenzenden Vieleck mindestens zwei Seiten einen überstumpfen Winkel β aufspannen, für den gilt: α + β = 360°. Dabei weist der erste Körper eine Ausnehmung auf, die wenigstens eine zwischen den den Winkel α aufspannenden Seiten liegende Kante des Prismas umfaßt, so daß sich der parallel zu dieser Kante verlaufende Kanal mit einem gleichförmigen Querschnitt zwischen dem ersten und dem angefügten zweiten Körper ausbildet und die Ausnehmung umfaßt.

Durch die erfindungsgemäße Bildung des Kanals durch zwei formschlüssig zusammenpassende von ebenen Flächen begrenzte Körper wird erreicht, daß ein wesentlicher Teil des Kanals bereits durch die Form der Körper vorgebildet ist. Der Kanal läßt sich somit beispielsweise durch einfaches Ausschneiden einer im Querschnitt L-förmigen Ausnehmung aus dem ersten Körper realisieren. Im Gegensatz zur Bildung eines U-förmigen Kanals läßt sich ein solcher Verarbeitungsschritt mit wesentlicher höherer Genauigkeit durchführen.

Viele zu transportierende Gegenstände haben im Querschnitt die Form von Parallelogrammen, insbesondere von Rechtecken. Daher ist es besonders vorteilhaft, den Kanal im Querschnitt als Parallelogramm auszuführen.

Weiterhin ist eine Vorrichtung zum Transport von Gegenständen besonders vorteilhaft, bei der die Ausnehmung im Querschnitt ein Quadrat mit einer Fläche kleiner als 0,6 mm × 0,6 mm ist und bei der α = 90° ist. Eine solche Vorrichtung ist zum einen besonders geeignet zum Transport kleiner Gegenstände mit dem Querschnitt der Ausnehmung entsprechenden Abmessungen. Darüber hinaus ist der Kanal dieser Vorrichtung besonders leicht aus einem L-förmigen Körper und einem quaderförmigen Körper, dessen eine Seitenkante durch eine L-förmige Ausnehmung ersetzt ist, zu realisieren.

Bei der erfindungsgemäßen Vorrichtung läßt sich die den Kanal bildende Ausnehmung in besonders einfacher Weise maßhaltig und mit glatten Wänden herstellen. Sie ist insbesondere geeignet für den Transport von Gegenständen mittels eines Luftstromes über größere Strecken. Demnach ist eine Vorrichtung zum Transport von Gegenständen besonders vorteilhaft, bei der die Länge der Ausnehmung und damit des Kanals größer als 400 mm ist.

Die erfindungsgemäße Vorrichtung zum Transport von Gegenständen kann besonders vorteilhaft zum Transport von elektrischen Bauelementen, insbesondere von Widerständen oder Kondensatoren, eingesetzt werden. Demnach kommt in besonders vorteilhafter Weise eine Verwendung der Vorrichtung in Zuführmodulen von Bestückautomaten zur Bestückung von Leiterplatten mit elektrischen Bauelementen in Betracht.

Im folgenden wird die Erfindung anhand zweier Ausführungsbeispiele und den dazugehörigen Figuren näher erläutert.

Figur 1 zeigt eine erste erfindungsgemäße Vorrichtung im schematischen Querschnitt.

Figur 2 zeigt eine zweite erfindungsgemäße Vorrichtung im schematischen Querschnitt.

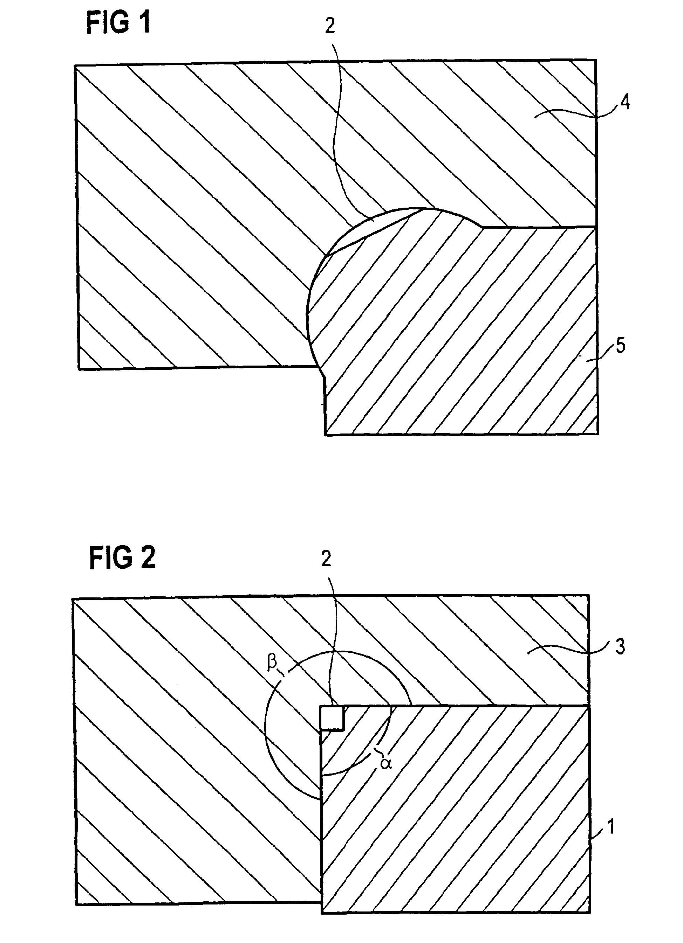

Figur 1 zeigt eine erfindungsgemäße Vorrichtung zum Transport von Gegenständen, bei der der Kanal 2 geformt ist durch Zusammenfügen eines Körpers 5 mit einer Oberfläche in Form einer konvexen Zylinderfläche und eines Körpers 4 mit einer Oberfläche in Form einer konkaven Zylinderfläche. Der Körper 5 enthält eine im Querschnitt kreissegmentförmige Ausnehmung 2, die durch gerades Abschneiden der Zylinderfläche hergestellt wurde und die den Kanal 2 bildet.

Figur 2 zeigt eine erfindungsgemäße Vorrichtung zum Transport von Gegenständen, bei der der Kanal 2 geformt ist durch Zusammenfügen eines Quaders 1 und eines L-förmigen Körpers 3. Der Quader 1 enthält eine im Querschnitt rechteckige Ausnehmung 2, die den Kanal 2 bildet.

Die Erfindung beschränkt sich nicht auf die beispielhaft gezeigten Ausführungsformen, sondern wird in ihrer allgemeinsten Form durch Anspruch 1 oder Anspruch 2 definiert.

## Patentansprüche

1. Vorrichtung zum Transport von Gegenständen mittels eines Luftstromes in einem Kanal (2), der geformt ist durch formschlüssiges Zusammenfügen
- eines ersten Körpers (5), aufweisend eine konvexe Oberfläche in Form einer gedachten Zylinderfläche mit
- einem zweiten Körper (4), aufweisend eine mit der Form der konvexen Oberfläche übereinstimmende konkave Oberfläche,
wobei der erste Körper (5) eine zumindest Teile der konvexen Oberfläche umfassende, geradlinige und parallel zur Längsachse des von der gedachten Zylinderfläche begrenzten Zylinders liegende Ausnehmung aufweist, so daß die Ausnehmung den Kanal bildet.

2. Vorrichtung zum Transport von Gegenständen mittels eines Luftstromes in einem Kanal (2), der geformt ist durch formschlüssiges Zusammenfügen
- eines ersten Körpers (1) in Form eines gedachten geraden Prismas, bei dem im dessen Grundfläche begrenzenden Vieleck zwei Seiten einen Winkel α < 180° aufspannen, mit
- einem zweiten Körper (3) in Form eines geraden Prismas, bei dem im dessen Grundfläche begrenzenden Vieleck zwei Seiten einen Winkel β aufspannen, für den gilt: α + β = 360°,
wobei der erste Körper (1) eine Ausnehmung (2) aufweist, die wenigstens eine zwischen den den Winkel α aufspannenden Seiten liegende Kante des Prismas umfaßt,
so daß sich der parallel zu dieser Kante verlaufende Kanal (2) mit einem gleichförmigen Querschnitt zwischen dem ersten und dem angefügten zweiten Körper (3) ausbildet und die Ausnehmung (2) umfaßt.

3. Vorrichtung nach Anspruch 1 oder 2,
bei der der Kanal (2) im Querschnitt ein Parallelogramm ist.

4. Vorrichtung nach Anspruch 1 bis 3,
bei der Winkel α = 90° ist und der Kanal (2) im Querschnitt ein Quadrat mit einer Fläche kleiner als 0,6 mm × 0,6 mm ist.

5. Vorrichtung nach Anspruch 1 bis 4,
bei der die Länge des Kanals (2) größer als 400 mm ist.

6. Verwendung der Vorrichtung nach einem der Ansprüche 1 bis 5, zum Transport von elektrischen Bauelementen.

7. Verwendung der Vorrichtung nach Anspruch 1 bis 5 zum Transport von Widerständen oder Kondensatoren.

8. Verwendung der Vorrichtung nach Anspruch 1 bis 7 in Zuführmodulen von Bestückautomaten.

## Claims

1. Device for transporting objects by means of an airflow in a channel (2), which is produced by joining interlockingly
- a first body (5), having a convex surface in the shape of an imaginary cylindrical surface, and
- a second body (4), having a concave surface matching the shape of the convex surface,
the first body (5) having a linear recess enclosing at least parts of the convex surface and lying parallel to the longitudinal axis of the cylinder delimited by the imaginary cylindrical surface, so that the recess forms the channel.

2. Device for transporting objects by means of an airflow in a channel (2) which is produced by joining interlockingly
- a first body (1), having the shape of an imaginary right prism, in which, in the polygon delimiting its base surface, two sides define an angle α < 180°, and
- a second body (3), having the shape of a right prism, in which, in the polygon delimiting its base surface, two sides define an angle β, such that α + β = 360°,
the first body (1) having a recess (2) enclosing at least an edge of the prism lying between the sides defining the angle α, so that the channel (2) extending parallel to this edge is formed with a uniform cross section between the first and the added second body (3) and encloses the recess (2).

3. Device according to Claim 1 or 2, in which the channel (2) is a parallelogram in cross section.

4. Device according to Claims 1 to 3, in which the angle α = 90° and the channel (2) is a square in cross section having a surface area less than 0.6 mm x 0.6 mm.

5. Device according to Claims 1 to 4, in which the length of the channel (2) is greater than 400 mm.

6. Use of the device according to one of Claims 1 to 5 for transporting electrical components.

7. Use of the device according to one of Claims 1 to 5 for transporting resistors or capacitors.

8. Use of the device according to one of Claims 1 to 7 in feed modules for automatic fitting machines.

## Revendications

1. Dispositif destiné au transport d'objets au moyen d'un courant d'air dans un canal (2) formé par assemblage, par adhérence de forme,
- d'un premier corps (5), présentant une surface convexe sous forme d'une surface cylindrique imaginaire, avec
- un deuxième corps (4) présentant une surface concave coïncidant avec la forme de la surface convexe,
le premier corps (5) présentant un évidement, comprenant au moins des parties de la surface convexe, rectiligne et parallèle à l'axe longitudinal du cylindre limitant la surface cylindrique imaginaire,
de sorte que l'évidement forme le canal.

2. Dispositif destiné au transport d'objets au moyen d'un courant d'air dans un canal (2) formé par assemblage, par adhérence de forme,
- d'un premier corps (1) sous forme d'un prisme droit imaginaire, dans lequel, dans le polygone limitant sa surface de base, deux côtés forment un angle α < 180°, avec
- un deuxième corps (3) sous forme d'un prisme droit, dans lequel, dans le polygone limitant sa surface de base, deux côtés forment un angle β, pour lequel on a : α + β = 360°,
le premier corps (1) présentant un évidement (2) comprenant au moins une arête du prisme, située entre les côtés formant l'angle α,
de sorte que le canal (2) s'étendant parallèlement à cette arête se forme, avec une section uniforme, entre le premier corps et le deuxième corps ajouté et qu'il comprend l'évidement.

3. Dispositif selon la revendication 1 ou 2,
dans lequel le canal (2) est un parallélogramme en section transversale.

4. Dispositif selon les revendications 1 à 3,
dans lequel l'angle α = 90° et le canal (2) est un carré en section transversale, ayant une surface inférieure à 0,6 mm x 0,6 mm.

5. Dispositif selon les revendications 1 à 4,
dans lequel la longueur du canal (2) est supérieure à 400 mm.

6. Utilisation du dispositif selon l'une quelconque des revendications 1 à 5, destinée au transport de composants électriques.

7. Utilisation du dispositif selon l'une quelconque des revendications 1 à 5, destinée au transport de résistances ou de condensateurs.

8. Utilisation du dispositif selon l'une quelconque des revendications 1 à 7 dans des modules d'alimentation d'automates pour le montage.
